(19) Europäisches Patentamt
European Patent Office
Office européen des brevets

(11) **EP 2 114 112 B1**

(12) **EUROPEAN PATENT SPECIFICATION**

(45) Date of publication and mention
of the grant of the patent:
**23.09.2015 Bulletin 2015/39**

(51) Int Cl.:
***H05H 1/00*** *(2006.01)*

(21) Application number: **08008191.2**

(22) Date of filing: **29.04.2008**

(54) **Apparatus for industrial plasma processes**

Vorrichtung für industrielle Plasmaprozesse

Appareil pour procédés industriels au plasma

(84) Designated Contracting States:
**AT BE BG CH CY CZ DE DK EE ES FI FR GB GR HR HU IE IS IT LI LT LU LV MC MT NL NO PL PT RO SE SI SK TR**

(43) Date of publication of application:
**04.11.2009 Bulletin 2009/45**

(73) Proprietor: **Plasmetrex GmbH**
**12489 Berlin (DE)**

(72) Inventors:
• **Klick, Michael, Dr.**
**12524 Berlin (DE)**

• **Rothe, Ralf, Dr.**
**15890 Eisenhüttenstadt (DE)**
• **Eichhorn, Lutz**
**12555 Berlin (DE)**

(74) Representative: **Zeitler Volpert Kandlbinder**
**Patent- und Rechtsanwälte Partnerschaft mbB**
**Postfach 26 02 51**
**80059 München (DE)**

(56) References cited:
**US-A- 5 861 752     US-A- 5 936 413**
**US-A1- 2003 227 283     US-A1- 2005 009 347**
**US-A1- 2007 074 811     US-A1- 2007 227 657**

**Description**

The invention relates to an apparatus for industrial plasma processes, like plasma etching, plasma enhanced chemical vapor deposition, and sputtering, for current measurement in unsymmetrical radio frequency (RF) low-pressure plasmas.

Such an apparatus is disclosed in U.S. patent 5,861,752. This known apparatus has the disadvantage of short lifetimes in special industrial applications due to fast erosion at the edge of the sensor electrode head, i.e. the head of the meter electrode. Said erosion is owing to higher field strength and a less compact protection layer, like for example anodized aluminium, at the edge of said head. On the other hand, it is obvious that a meter electrode being eroded at its head should not be used for reliable and precise RF measurements. It is to be pointed out that the above mentioned apparatus is particular suitable for the measurement of the RF discharge current at a portion of a plasma reactor acting as earth electrode. It goes without saying that such measurements are only useful if the determined current is exactly measured.

Document US 5,936,412 A discloses a measurement device for measuring an ion flow from a plasma with a probe and a conductor connected thereto that runs through a wall.

Document US 2005/009347 A1 discloses an apparatus for measuring plasma electron density using a probe arranged in the wall of a chamber.

Document US 2007/0074811 A1 discloses an apparatus for measuring plasma density of a plasma processing reactor comprising a probe having a dielectric tube with a coaxial cable inserted therein.

It is an object of the present invention to provide an apparatus as mentioned above by which the measurements can reliably and precisely be made and the wear-resistance and lifetime of which is improved.

This object is solved by an apparatus comprising the features of claim 1.

Further embodiments of the present invention are mentioned in the sub-claims.

According to the present invention, the apparatus is designed such that the following equation is approximately met:

$$Z_0 = \sqrt{\frac{\mu_r}{\varepsilon_r}} \; 60\,\Omega \; \ln\frac{D}{d} = 50 \text{ or } 75 \;\Omega$$

wherein $Z_0$ is the characteristic impedance of the apparatus, $\mu_r$ is the relative permeability and $\varepsilon_r$ is the dielectric constant of the dielectric, respectively, $D$ is the diameter of a flange or recess within a wall of a chamber, and $d$ is the diameter of the inner conductor of the meter electrode. By said equation, dimensions of main elements of the apparatus and main properties of the dielectric as insulating material to be selected are connected with each other. The relative permeability $\mu_r$ and the dielectric constant $\varepsilon_r$ as mentioned above are dimensionless physical quantities. The chamber as mentioned before normally is a part of a plasma reactor. By means of said equation it is easily possible to select the relative permeability $\mu_r$ and the dielectric constant $\varepsilon_r$ together with the two diameters mentioned before such that the desired value for the characteristic impedance $Z_0$, namely 50 $\Omega$ or 75 $\Omega$, is met. Such an apparatus is more robust, reliable and precise if compared to prior art apparatus as disclosed in the above mentioned U.S. patent. As a result, reflections and thus distortions of the RF current transmission from the plasma to the apparatus, e.g. a digitizer with very high bandwidth, can be avoided during signal transmissions up to 1 GHz. In order to avoid such reflections and distortions the characteristic impedances of meter electrode, cable(s) and connectors as well as the input impedance of the apparatus should be equal.

The meter electrode has a front which is covered by a wear-resistant, dielectric RF window, preferably a ceramic plate, through which the RF is measured. By this a wear-resistant apparatus having improved robustness and lifetime is achieved. Any erosion of the head of the meter electrode is efficiently avoided. Said RF window may be in the form of an additional ceramic cover.

Said RF window has a thickness w of about 0.5 to 20 mm and a dielectric constant $\varepsilon_r$ of about 1.4 to 20, due to ceramics as $Al_2O_3$ used usually of 10, such that the electrical thickness $w_{El}$ of the insulating material of said RF window meets the following equation:

$$w_{El} = \frac{w}{\varepsilon_r} < 1 \text{ mm}$$

Such an apparatus enables that the desired current may very precisely be measured.

According to a further embodiment of the present invention the inner diameter of said flange or recess is greater than the diameter of the meter electrode which is preferably greater than 3 mm, more preferably greater than 5 mm. An apparatus according to this embodiment provides a sufficient, high frequency signal from the RF driven plasma.

According to another embodiment of the present invention said RF window is arranged at the inner wall of the chamber directed to the interior space thereof. Thus, there is no direct contact between the plasma within the interior space of the chamber of the reactor and the surface of the meter electrode. An apparatus according to this embodiment is very robust, reliable and measures the relevant physical quantity, namely the RF discharge current, very precisely. Furthermore, lifetime of such an apparatus is considerably improved.

According to a further embodiment of the present invention, the front end of said RF window is provided, preferably by deposition, with a layer similar or identical to the inner surface of said chamber, for example $Al_2O_3$ or $Y_2O_3$. With such an apparatus chemical and physical properties at the surface of the meter electrode may be the same as those in many industrial plasma etch chambers.

According to yet another embodiment of the present invention, the connection between the meter electrode and the RF window is realized by a ball-shaped head of said meter electrode and a spherical cavity in the RF window accommodating said head. This embodiment is especially suitable for wear-resistant and self-aligned apparatus for RF current measurements at non-perpendicular walls or wall protectors (liners) in etch and deposition RF plasma reactors.

According to another embodiment not part of the present invention a gap is provided between the meter electrode and the flange or recess in the wall of the chamber, and the dielectric is recessed such that there is a distance between the front of said meter electrode and the front end of said dielectric. According to this embodiment the differences of the diameter of the flange or recess in the chamber wall and the diameter of the meter electrode are designed such that metal particles coming from the deposition plasma cannot reach the recessed dielectric (insulator) under normal industrial conditions. Thus, a built-up of a continuous conducting layer on the surface of the dielectric as well as a current flow between the electrode and the grounded chamber wall is efficiently avoided. For this reason the gap between the meter electrode and the flange or recess in the chamber wall should not be too small in order to avoid a direct short between meter electrode and chamber wall. According to this embodiment the dielectric is "shadowed" by the meter electrode.

According to still another embodiment of the present invention the dielectric is designed to fix the meter electrode, preferably by separate insulator pieces, and vacuum is provided between said pieces for insulation purposes. This embodiment allows to reduce the average dielectric constant as mentioned before and enables to gain additional flexibility with respect to the design of the whole apparatus.

Embodiments of the present invention are explained below only by way of example. The scope of the protection is defined by the claims, however, a better understanding of the invention will be reached by reference to the following detailed description of embodiments of the present invention when read in conjunction with the accompanying drawings, in which

Fig. 1    shows a schematic, sectional view of an apparatus according to the present invention for industrial plasma processes according to a first embodiment;

Fig. 2    shows a schematic, sectional view of an apparatus according to the present invention for industrial plasma processes according to a second embodiment;

Fig. 3    shows a schematic, perspective view partly in cross-section of the apparatus according to Fig. 2 in a different arrangement;

Fig. 4    shows a schematic, sectional view of an apparatus without an RF window for industrial plasma processes according to a third embodiment not part of the invention shown for exemplary puroposes;

Fig. 5    shows a schematic, perspective view partly in cross-section of the apparatus according to Fig. 4;

Fig. 6    shows a schematic, sectional view of an apparatus without an RF window for industrial plasma processes according to a fourth embodiment not part of the invention shown for exemplary purposes;

Fig. 7    shows a schematic, perspective view partly in cross-section of the apparatus according to Fig. 6;

Fig. 8    shows a schematic, sectional view of an apparatus without an RF window for industrial plasma processes according to a fifth embodiment not part of the invention shown for exemplary purposes; and

Fig. 9    shows a schematic, perspective view partly in cross-section of the apparatus according to Fig. 8.

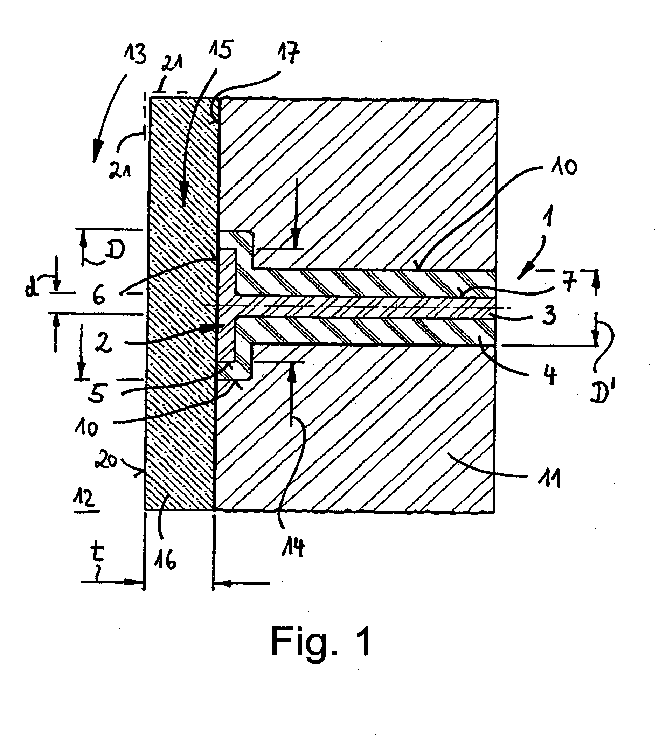

In Fig. 1 a schematic, sectional view of an apparatus 1 for industrial plasma processes, like plasma etching, plasma enhanced chemical water deposition and sputtering, for current measurement in unsymmetrical radio frequency (RF) low-pressure plasmas is shown.

Said apparatus 1 comprises a meter electrode 2 having an inner conductor 3 connected thereto and a dielectric 4 as electrical insulator at least on a part of its peripheral surface 5. According to Fig. 1 dielectric 4 completely covers the peripheral surface 5 of meter electrode 2 except the front 6 thereof. Furthermore, dielectric 4 completely covers the peripheral surface 7 of said inner conductor 3.

Meter electrode 2 together with its dielectric 4 is positioned in a flange or recess 10 within a wall 11 of a chamber 12. It is to be noted that from said chamber 12 only a part of wall 11 is shown in Fig. 1 and that the interior space 13 of said chamber 12 is completely closed by further wall elements. It is obvious that the other walls of said chamber, like for example the top wall, the bottom wall and other side walls, are not shown in Fig. 1. According to the embodiment of the present invention as shown in Fig. 1 also a part of the inner conductor 3 of meter electrode 2 is located in said flange or recess 10.

According to the present invention the following equation is approximately met:

$$Z_0 = \sqrt{\frac{\mu_r}{\varepsilon_r}} \, 60 \, \Omega \, \ln \frac{D}{d} = 50 \, \Omega \text{ or } 75 \, \Omega \qquad (1)$$

wherein $Z_0$ is the characteristic impedance of apparatus 1, $\mu_r$ is the relative permeability and $\varepsilon_r$ is the dielectric constant of dielectric 4, respectively, $D$ is the diameter of said flange or recess 10 and $d$ is the diameter of said inner conductor 3 of meter electrode 2.

As indicated in Fig. 1 flange or recess 10 has a greater diameter $D$ in the region where meter electrode 2 is located and a smaller diameter $D'$ in the part where the inner conductor 3 of meter electrode 2 is located within chamber wall 11. As indicated in the embodiment according to Fig. 1 the diameter $D$ of said flange or recess 10 is greater than the diameter 14 of meter electrode 2, said meter electrode diameter being preferably greater than 3 mm, more preferably greater than 5 mm.

According to the present invention meter electrode 2 has a front 6 which is covered by a wear resistant, dielectric RF window 15, preferably a ceramic plate 16, through which the RF is measured. As shown in Fig. 1, said RF window 15 is arranged at the inner wall 17 of chamber 12 directed to the interior space 13 of said chamber. It is to be noted that the length of said ceramic plate should be greater than diameter 14 of meter electrode 2, preferably greater than diameter $D$ of flange or recess 10, accommodating said meter electrode 2.

Said RF window 15 has a thickness $w$ of about 0.5 to 20 mm and a dielectric constant $\varepsilon_r$ of about 1.4 to 20, preferably of 10, such that the electrical thickness $w_{El}$ of the insulating material of said RF window 15 meets the following equation:

$$w_{El} = \frac{w}{\varepsilon_r} < 1 \text{ mm} \qquad (2)$$

Thus, the thickness $w$ of said RF window and the material of said window are selected such that equation (2) is satisfied.

According to a further embodiment of the present invention the front end 20 of RF window 15 is provided, preferably by deposition, with a layer 21 similar or identical to the inner surface of inner wall 17 of chamber 12. Layer 21 may be made for example of aluminium hydroxide, $Al_2O_3$, or yttrium oxide, $Y_2O_3$. It is to be noted that said layer is indicated in Fig. 1 only on a part of the outer surface of RF window 15 formed as said ceramic plate 16.

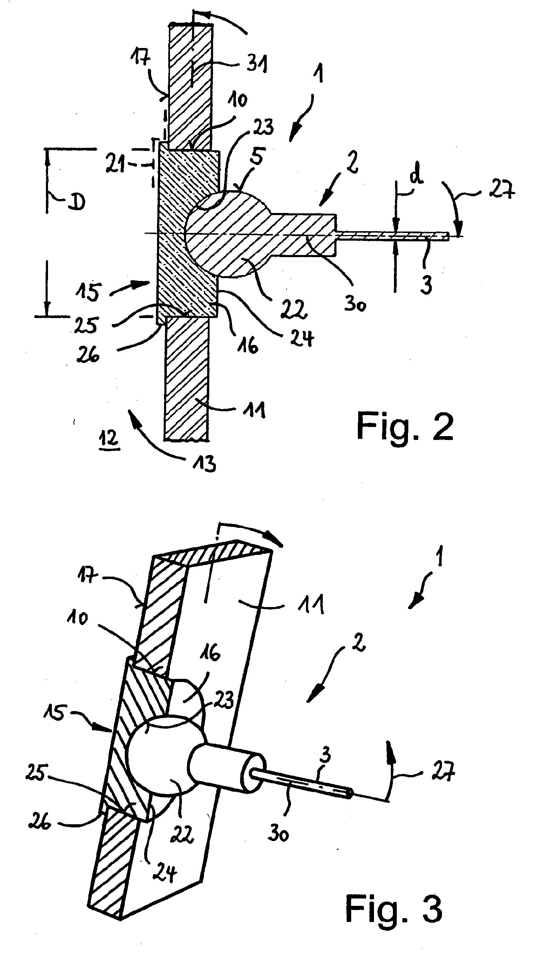

A second embodiment of the present invention is shown in Figs. 2 and 3.

According to this embodiment, the connection between meter electrode 2 and RF window 15 is realized by a ball-shaped head 22 of meter electrode 2 and a spherical cavity 23 provided in the rear side 24 thereof in which spherical cavity 23 said head 22 is accommodated. Also in this embodiment RF window 15 is made of a ceramic material.

According to Fig. 2 the RF window 15 has a peripheral recess 25 having a smaller diameter than the outer part 26 thereof. Said outer part 26 of said RF window 15 which is made of ceramic plate 16 is in contact with inner wall 17 of wall chamber 12. Thus, the RF window 15 with its recess 25 is accommodated in the flange or recess 10 of the wall 11 of chamber 12.

Further according to Fig. 2 the angle 27 between the longitudinal axis 30 of meter electrode 2 and longitudinal axis 31 of the wall 11 of chamber 12 is 90°. However, the embodiment as indicated in Figs. 2 and 3 may especially be used in non-perpendicular walls in etch and deposition RF plasma reactors. Such an application is indicated in Fig. 3 showing a schematic perspective view, partly in cross-section, of the embodiment of Fig. 2. According to Fig. 3 the angle 27 between longitudinal axis 30 of meter electrode 2 and longitudinal 31 of the wall is smaller than 90°. It is to be stated that said angle may be greater than 90° in other applications, i.e. where the longitudinal axis 30 of the meter electrode 2 is not perpendicular to the wall 11. Thus, this embodiment may easily be adapted to non-perpendicular arrangements. In this embodiment RF window 15 formed for example as ceramic plate 16 also functions as dielectric or insulator between meter electrode 2 and the chamber wall 11.

If there is a distance between the meter electrode 2 and the RF window 15, said distance is typically smaller than the electrical thickness $w_{El}$ of said RF window 15.

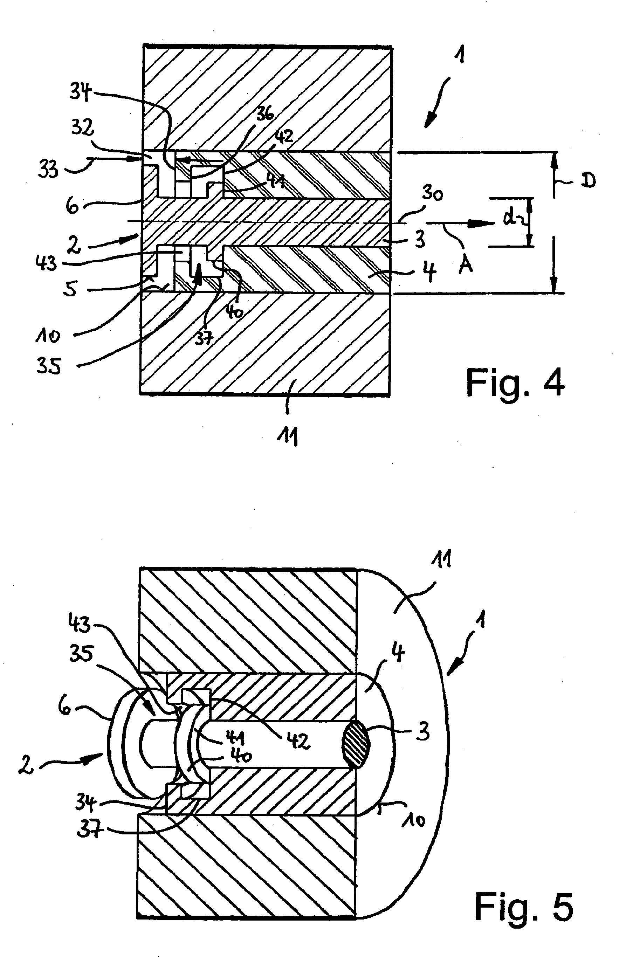

A further embodiment not part of the invention is shown in Figs. 4 and 5. Fig. 4 is a schematic sectional view of the apparatus. In Fig. 5 a schematic, perspective view, partly in cross-section, of the embodiment of Fig. 4 is shown.

According to this embodiment, a gap 32 is provided between the meter electrode 2 and the flange or recess 10 in the wall 11 of the chamber 12. The gap is formed like a circular ring between the peripheral surface 5 of meter electrode 2 and the flange or recess 10 designed in the wall 11. Furthermore, the dielectric 4 is recessed such that there is a distance 33 between the front 6 of said meter electrode 2 and the front end 34 of said dielectric 4. According to Figs. 4 and 5 meter electrode 2 has a groove 35 in its peripheral surface to which a projecting part 36 of electrical insulator 4 is directed. Joined to this projecting part 36 is a groove 37 in dielectric 4, which groove is directed and, therefore, opened to the meter electrode 2.

Meter electrode 2 has in the region of its inner conductor a projecting part 40 which is directed to groove 37 formed in the dielectric 4. The arrangement is such that the rear side 41 of said projecting part 40 of said meter electrode 2 abuts against side face 42 of said groove 37 of said dielectric 4, said side face 42 of said groove 37 being directed to projecting part 36 of said dielectric and the front 6 of meter electrode 2.

In Fig. 4 on the left side thereof the dielectric 4 has a central opening 43 which is designed such that meter electrode 2 together with its projecting part 40 is insertable there through in Fig. 4 from the left side in direction of arrow A. In other words, the outer diameter of projecting part 40 of meter electrode 2 is somewhat smaller than the inner diameter of opening 43 in the dielectric 4.

Fig. 5 is a schematic, perspective view of the embodiment of Fig. 4, partly in cross-section.

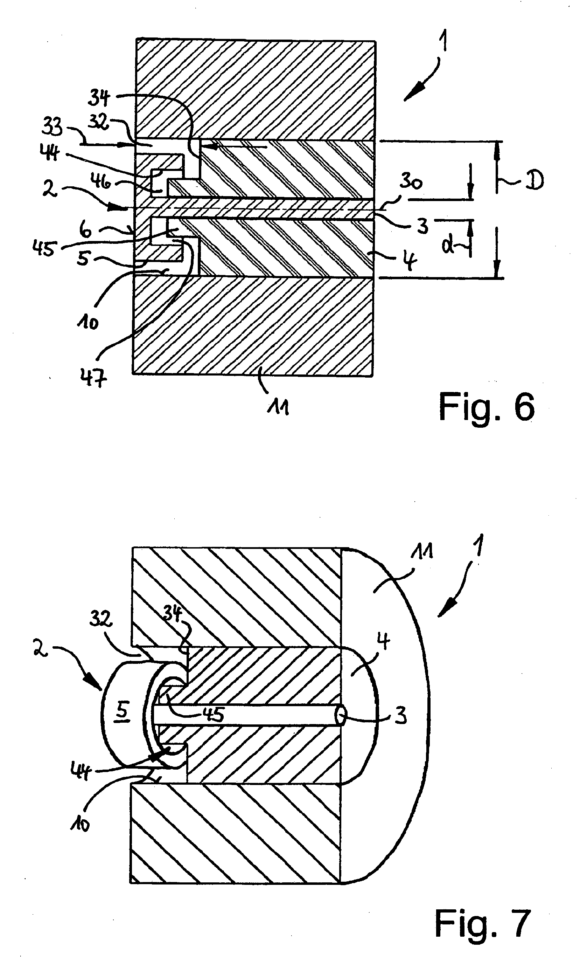

A further embodiment not part of the invention is shown in Figs. 6 and 7.

Also in this embodiment the gap 32 is provided between the peripheral surface 5 of meter electrode 2 and the flange or recess 10 provided within wall 11. Also with this embodiment the dielectric 4 is recessed such that there is the distance 33 between the front 6 of the meter electrode 2 and the front end 34 of the dielectric 4. In this embodiment, meter electrode 2 has on its rear side opposed to its front 6 an angular groove 44. The front end 34 of dielectric 4 is provided with an angular projecting part 45 which is partly inserted into the angular groove 44 of said meter electrode 2 such that there is an axial gap 46 and a radial gap 47 between said projecting part 45 and meter electrode 2. As shown in Figs. 6 and 7 meter electrode 2 with its inner conductor 3 and the dielectric 4 are inserted into each other and both, meter electrode and dielectric, are positioned within the flange or recess 10 within the chamber wall 11.

As indicated in Figs. 5 and 7 the wall 11 may circularly be formed. It is, however, clear that wall 11 may also be in form of a rectangular plate.

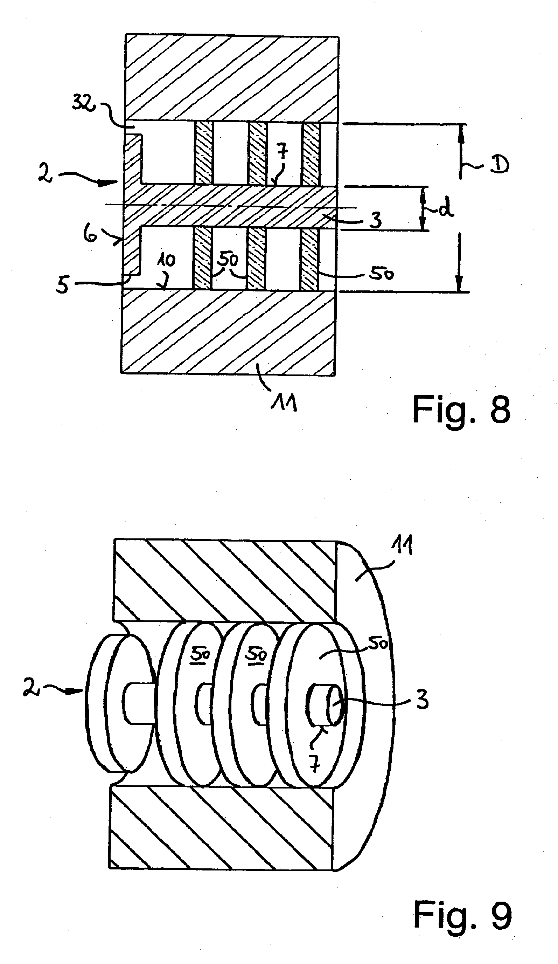

Yet another embodiment not part of the invention is shown in Figs. 8 and

In this embodiment, the dielectric 4 is designed to fix the meter electrode 2 by separate insulator pieces 50 which are located on the peripheral surface 7 of inner conductor 3 of meter electrode 2 within the flange or recess 10 of chamber wall 11. According to said embodiment three insulator pieces 50 are provided between meter electrode 2 and chamber wall 11. Furthermore, vacuum is provided between said pieces 50 for insulation purposes. Also in this embodiment, the gap 32 is provided between the meter electrode 2 and the flange or recess 10 in the chamber wall 11.

The embodiments according to Figs. 4 to 9 are especially suited for RF current measurements in metal and electro-conductive layer deposition for industrial plasma processes. According to these embodiments the dielectric 4 is arranged only on the peripheral surface 7 of the inner conductor 3 of the meter electrode 2.

As a result, an apparatus for industrial plasma processes is provided which is more robust, reliable and precise than prior art devices and has a long lifetime.

## Claims

1. Apparatus for industrial plasma processes, like plasma etching, plasma enhanced chemical vapour deposition and sputtering, for current measurement in unsymmetrical radio frequency (RF) low-pressure plasmas, comprising
a meter electrode (2) having an inner conductor (3) connected thereto and a dielectric (4) at least on a part of its peripheral surface (5),
the meter electrode (2) together with its dielectric (4) being positioned in a flange or recess (10) within a wall (11) of a chamber (12) of a plasma reactor,
said apparatus being designed such that the following equation is approximately met:

$$Z_0 = \sqrt{\frac{\mu_r}{\varepsilon_r}}\ 60\,\Omega\ \ln\frac{D}{d} = 50 \text{ or } 75\ \Omega,$$

wherein $Z_0$ is the characteristic impedance of the apparatus (1), $\mu_r$ is the relative permeability and $\varepsilon_r$ is the dielectric constant of the dielectric (4), respectively, $D$ is the diameter of said flange or recess (10) and d is the diameter of said inner conductor (3) of the meter electrode (2),

**characterized in that** the meter electrode (2) has a front (6) which is covered by a wear-resistant, dielectric RF window (15), preferably by a ceramic plate (16), through which the RF is measured, said RF window (15) having a thickness w of about 0.5 to 20 mm and a dielectric constant $\varepsilon_r$ of about 1.4 to 20, preferably of 10, such that the electrical thickness $w_{El}$ of the material of said RF window (15) meets the following equation:

$$w_{El} = \frac{w}{\varepsilon_r} < 1mm.$$

2. Apparatus according to claim 1, **characterized in that** the diameter ($D$) of said flange or recess (10) is greater than the diameter (14) of the meter electrode (2) which is preferably greater than 3 mm, more preferably greater than 5 mm.

3. Apparatus according to one of the foregoing claims **characterized in that** said RF window (15) is arranged at the inner wall (17) of the chamber (12) directed to the interior space (13) thereof.

4. Apparatus according to one of the foregoing claims, **characterized in that** the front end (20) of said RF window (15) is provided, preferably by deposition, with a layer (21) similar or identical to the inner surface of said chamber (12), for example $Al_2O_3$ or $Y_2O_3$.

5. Apparatus according to one of the foregoing claims, **characterized in that** the connection between the meter electrode (2) and the RF window (15) is realized by a ball-shaped head (22) of said meter electrode (2) and a spherical cavity (23) in the RF window (15) accommodating said head (22).

6. Apparatus according to one of the foregoing claims, **characterized in that** the dielectric (4) is designed to fix the meter electrode (2), preferably by separate insulator pieces (50), and vacuum is provided between said pieces (50) for insulation purposes.

**Patentansprüche**

1. Vorrichtung für industrielle Plasma-Prozesse, wie Plasma-Ätzen, Plasma unterstützte, chemische Dampfabscheidung und Zerstäuben zur Strommessung bei unsymmetrischer Radiofrequenz (RF) in Niederdruckplasmen, umfassend eine Meßelektrode (2) mit einem inneren Leiter (3), der an sie angeschlossen ist und ein Dielektrikum (4), das wenigstens auf einem Teil ihrer Umfangsoberfläche (5) vorhanden ist, wobei die Meßelektrode (2) zusammen mit ihrem Dielektrikum (4) in einem Flansch oder einer Aussparung (10) innerhalb einer Wand (11) einer Kammer (12) eines Plasmareaktors angeordnet ist und die Vorrichtung so gebaut ist, daß die folgende Gleichung annähernd erfüllt wird:

$$Z_0 = \sqrt{\frac{\mu_r}{\varepsilon_r}}\ 60\ \Omega\ \ln\frac{D}{d} = 50\ or\ 75\ \Omega,$$

wobei $Z_0$ der charakteristische Scheinwiderstand der Vorrichtung (1) ist, $\mu_r$ die relative Permeabilität und $\varepsilon_r$ die Dielektrizitätskonstante des Dielektrikums (4) sind, D der Durchmesser des Flansches und der Aussparung (10) ist und d der Durchmesser des inneren Leiters (3) der Meßelektrode (2) sind, **dadurch gekennzeichnet, daß** die Meßelektrode (2) eine Front (6) aufweist, die mit einem verschleißbeständigen, dielektrischen RF-Fenster (15) versehen ist, und zwar vorzugsweise durch eine keramische Platte (16), durch die die RF gemessen wird, wobei das RF-Fenster (15) eine Dicke w von etwa 0,5 bis 20 mm aufweist und eine Dielektrizitätskonstante $\varepsilon_r$ von etwa 1,4 bis 20, vorzugsweise 10 hat, derart, daß die elektrische Dicke $w_{\varepsilon 1}$ des Materials des RF-Fensters (15) der folgenden Gleichung entspricht:

$$w_{El} = \frac{w}{\varepsilon_r} < 1mm.$$

**2.** Vorrichtung nach Anspruch 1, **dadurch gekennzeichnet, daß** der Durchmesser (D) des Flansches oder der Aussparung (10) größer ist als der Durchmesser (14) der Meßelektrode (2), der vorzugsweise größer als 3 mm und besser noch größer als 5 mm ist.

**3.** Vorrichtung nach einem der vorhergehenden Ansprüche, **dadurch gekennzeichnet, daß** das RF-Fenster (15) in der Innenwand (17) der Kammer (12) angeordnet und zu ihrem Innenraum (13) ausgerichtet ist.

**4.** Vorrichtung nach einem der vorhergehenden Ansprüche, **dadurch gekennzeichnet, daß** das vordere Ende (20) des RF-Fensters (15) vorzugsweise durch Abscheidung mit einer Schicht (21) versehen ist, die ähnlich oder identisch der inneren Oberfläche der Kammer (12) ist, vorzugsweise $Al_2O_3$ oder $Y_2O_3$.

**5.** Vorrichtung nach einem der vorhergehenden Ansprüche, **dadurch gekennzeichnet, daß** die Verbindung zwischen der Meßelektrode (2) und dem RF-Fenster (15) durch einen kugelförmigen Kopf (22) der Meßelektrode (2) verwirklicht ist sowie einen kugelförmigen Hohlraum (23) in dem RF-Fenster (15), der den Kopf (22) aufnimmt.

**6.** Vorrichtung nach einem der vorhergehenden Ansprüche, **dadurch gekennzeichnet, daß** das Dielektrikum (4) so ausgebildet ist, daß es an der Meßelektrode (2) haftet, vorzugsweise durch getrennte Isolierstücke (50), und daß zwischen diesen Stücken (50) zu Isolierzwecken ein Vakuum ausgebildet ist.

**Revendications**

**1.** Dispositif pour procédés industriels au plasma, tels que la gravure au plasma, le procédé de dépôt chimique en phase vapeur assisté par plasma et la pulvérisation, pour mesurer un courant dans des plasmas asymétriques radiofréquence (RF) basse pression, comprenant une électrode de mesure (2) ayant un conducteur interne (3) connecté à celle-ci et un diélectrique (4) au moins sur une partie de sa surface périphérique (5), l'électrode de mesure (2) et son diélectrique (4) étant positionnés dans un rebord ou un renfoncement (10) à l'intérieur d'une paroi (11) d'une chambre (12) d'un réacteur au plasma, ledit dispositif étant conçu de sorte que l'équation suivante soit approximativement satisfaite :

$$Z_0 = \sqrt{\frac{\mu_r}{\varepsilon_r}}\ 60\,\Omega\ \ln\frac{D}{d} = 50 \text{ or } 75\ \Omega,$$

dans laquelle $Z_0$ est l'impédance caractéristique du dispositif (1), $\mu_r$ est la perméabilité relative et $\varepsilon_r$ est la constante diélectrique du diélectrique (4), respectivement, D est le diamètre dudit rebord ou renfoncement (10) et d est le diamètre dudit conducteur interne (3) de l'électrode de mesure (2), **caractérisé en ce que** l'électrode de mesure (2) présente un avant (6) qui est couvert par une fenêtre RF diélectrique résistante à l'usure (15), de préférence par une plaque céramique (16), à travers laquelle la RF est mesurée, ladite fenêtre RF (15) ayant une épaisseur $w$ d'environ 0,5 à 20 mm et une constante diélectrique $\varepsilon_r$ d'environ 1,4 à 20, de préférence de 10, de sorte que l'épaisseur électrique $w_{El}$ du matériau de ladite fenêtre RF (15) satisfasse l'équation suivante :

$$w_{El} = \frac{w}{\varepsilon_r} < 1mm.$$

**2.** Dispositif selon la revendication 1, **caractérisé en ce que** le diamètre (D) dudit rebord ou renfoncement (10) est supérieur au diamètre (14) de l'électrode de mesure (2) qui est de préférence supérieur à 3 mm, de manière davantage préférée supérieur à 5 mm.

3. Dispositif selon l'une quelconque des revendications précédentes, **caractérisé en ce que** ladite fenêtre RF (15) est agencée au niveau de la paroi interne (17) de la chambre (12) dirigée vers l'espace intérieur (13) de celui-ci.

4. Dispositif selon l'une quelconque des revendications précédentes, **caractérisé en ce que** la face avant (20) de ladite fenêtre RF (15) est équipée, de préférence par dépôt, d'une couche (21) similaire ou identique à la surface interne de ladite chambre (12), par exemple $Al_2O_3$ ou $Y_2O_3$.

5. Dispositif selon l'une quelconque des revendications précédentes, **caractérisé en ce que** la connexion entre l'électrode de mesure (2) et la fenêtre RF (15) est réalisée au moyen d'une tête sphérique (22) de ladite électrode de mesure (2) et une cavité sphérique (23) dans la fenêtre RF (15) accueillant ladite tête (22).

6. Dispositif selon l'une quelconque des revendications précédentes, **caractérisé en ce que** le diélectrique (4) est conçu de manière à accrocher l'électrode de mesure (2), de préférence au moyen de composants isolants distincts (50), et un vide est fourni entre lesdits composants (50) à des fins d'isolation.

Fig. 1

Fig. 2

Fig. 3

Fig. 4

Fig. 5

Fig. 6

Fig. 7

Fig. 8

Fig. 9

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5861752 A
- US 5936412 A
- US 2005009347 A1
- US 20070074811 A1